# EUROPEAN PATENT SPECIFICATION

(11) **EP 0 427 901 B1**
(45) Date of publication and mention of the grant of the patent: **03.04.1996**
(21) Application number: 89810871.7
(22) Date of filing: 14.11.1989
(51) Int. Cl.: H01L 41/08

(54) **Method of manufacturing a multilayer piezoelectric actuator stack**
Verfahren zur Herstellung einer piezoelektrischen Stapelantriebsvorrichtung
Procédé de fabrication d'un actionneur à couches piézoélectriques empilées

(43) Date of publication of application: 22.05.1991
(73) Proprietor: BATTELLE MEMORIAL INSTITUTE, CH-1227 Carouge/Genève (CH)
(72) Inventor: Issartel, Jean-Paul, F-74100 Annemasse (FR)
(74) Representative: Dousse, Blasco

(56) References cited:
- Proc. 6th IEEE International Symposium on Applications of Ferroelectrics; Bethlehem,PA,USA,8-11 June 1986; pages 652 - 655; W.Wersing et al.: "Multilayer piezoelectric ceramic actuators."
- Patent Abstract of Japan, Vol. 010082 (E392), 2 April 1986 & JP-A-60 229 380

## Description

The present invention concerns a method for manufacturing multilayer piezoceramic actuator stack.

Actuators of the multilayer stacked type generally consist of a laminate block of alternate piezoceramics and electrode layers stacked over each other. Each group of even and odd numbered electrodes are connected to a current collector, generally an outer electrode applied on the side faces of the block perpendicular to the laminate. In order that the odd electrodes do not short with the even collector on the opposite side of the block, or vice-versa, the length of the electrodes in each group is limited to be less than the width of the block so that the tip of each electrode is separated from the collector of the opposite group by a discontinuity.

However this kind of construction is impeded due to mechanical brittleness at the staggered internal electrodes. When an electric field is applied, the interdigital electrode type develops tensile stresses large enough to make a gap on the electrode plane around the boundary between electrostrictively active and inactive parts. One solution is the use of modified electrode patterns (so-called "plate through" electrodes) in eclipsed configuration to eliminate the tensile stress. In this embodiment, the electrodes are not interrupted and cross-out through the block which removes the transversal physical constraints due to structure inhomogeneity. However, this construction does not remove longitudinal anisotropy (succession of plain ceramic and electrode layers) and further, the electrode tip in each group must be insulated individually not to interfere with the electric collector connected to the opposite group of electrodes, which requirement complicates the construction (see S. TAKAHASHI, New Materials & New Processes 3 (1985), 63-68). Another solution is to use ceramic electrodes instead of metal electrodes to improve mechanical toughness (K. UCHINO, "Essentials to Development and Applications of Piezoelectric Actuators", in Electronics Essential Series No. 3, Japanese Industrial Technology Center, Tokyo 1984). However ceramic electrodes are generally thicker than corresponding metal electrodes and the introduction of such a substantial amount of foreign material may interfere with the dynamic efficiency of the interlaid piezoceramic layers.

JP-A-60229380 has already proposed to overcome this drawback by manufacturing the laminate by superposing a plurality of green sheets consisting of piezoelectric ceramics, baking the laminate to shape air grap sections and filling the air gap sections with an insulator. For achieving this result a strip of a material disappearing by heating is shaped along the end side of a rectangular green sheet. A plurality of the green sheets are superposed with electrode sections, thus shaping a laminate. The material of the strips disappears by baking the laminate and air gap sections are formed alternatively on two opposed side faces of the laminate and are filled with an insulator. Electrode leads are formed on two opposed side faces of the laminate and contact only the internal electrodes which are not protected by an insulator.

It has also been proposed in Proc. 6th IEEE International Symposium on Applications of Ferroelectrics; Bethlehem, PA, USA, 8-11 June 1986; pages 652-655; W. Versing et al.; "Multilayer piezoelectric ceramic actuator", to form internal electrodes in a multilayer actuator with a paste comprised of organic binder and a small amount of powdered ceramic. During firing this organic binder burns away leaving random openings between the ceramic layers which are impregnated under pressure with metal.

The aforementioned openings constitute sort of ceramic pillars or columns which locally bind together, across the intermediate electrode layer, one piezoceramic layer to the next and strongly reinforce the mechanical properties of the whole stack.

The present invention aims at a method in which a pattern of ceramic pillars or columns which bind together adjacent ceramic layers through internal electrodes inserted between these ceramic layers is formed by using ceramic impregnated fabrics, as defined in claim 1.

The invention is disclosed in more detail with reference to the annexed drawing.

Fig. 1 is a schematic illustration of the principle of the invention with reference to a first embodiment.

Fig. 2 is a schematic cross-sectional view of a piezoelectric actuator stack according to the invention.

Fig. 3 is a schematic view in perspective of an element of an actuator according to the invention.

Fig. 4 and fig. 5 illustrate one manufacturing embodiment of the actuators of the invention.

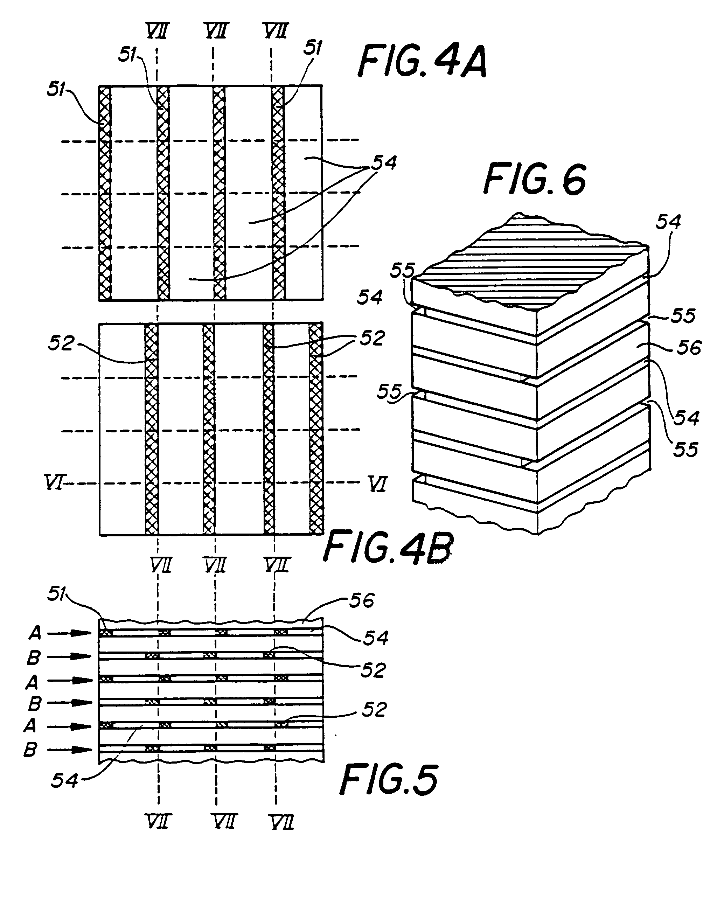

Fig. 4 is a top view of two sheet elements A and B to be consecutively stacked over each other in making a stack of piezoceramic and electrode layers.

Fig. 5 is a vertical cross-section along line VI-VI of a portion of a stack made with successive elements of the A and B type.

Fig. 6 is a schematic view in perspective of an actuator in non-terminated form which results from the cutting of the stack of fig. 5 along lines VI-VI and VII-VII.

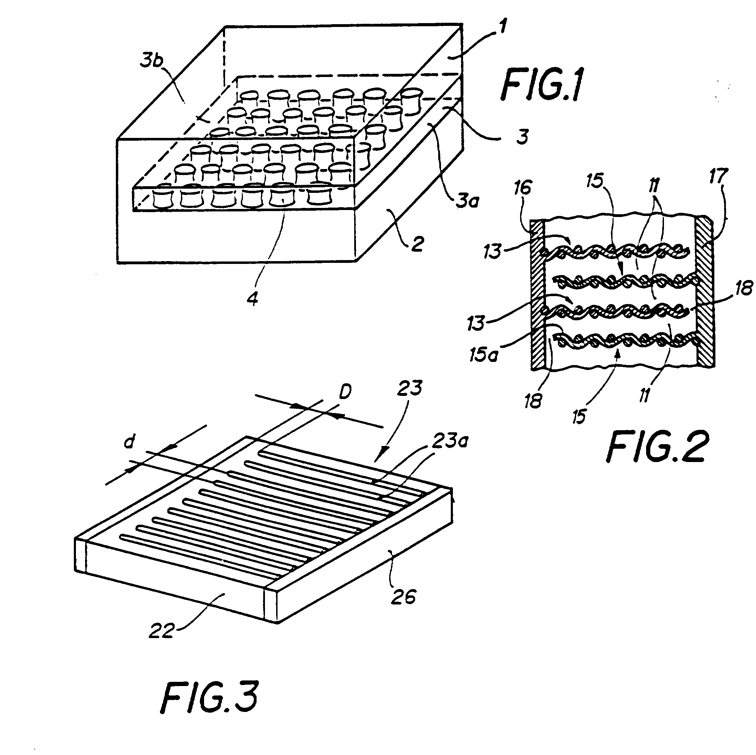

Fig. 1 shows schematically a portion of a multilayer actuator in stack form, i.e. one of the piezoresponsive ceramic layers 1 and the next piezoceramic layer 2, these layers 1 and 2 being separated by an electrode layer 3. The electrode layer 3 is provided with a plurality of through-holes (wormholes) 4 filled with the same piezoceramic that constitutes the piezoresponsive layers. This filling is achieved during construction when the electrodes or electrode precursors are embedded in the ceramic composition before sintering as will be disclosed hereafter.

The conductive layer 3 stops flush with one of the side faces of layers 1 and 2 (see reference numeral 3a). This is for connection with a side collector electrode not shown. In contrast, on the opposite side of the stack, the conductive layer is interrupted and is limited by a piezoceramic striplike border 3b. This corresponds to a staggered electrode configuration. The width of this limiting (and electrically insulating) border 3b is preferably of the same order of magnitude as the size of the wormholes 4. Hence the mechanical properties of the ceramic stack are reinforced and equilibrated by the trussing action of the ceramic connecting members 4; a structure of this kind will prevent the formation of undesirable gaps on the electrode plane during operation of the actuator. Naturally, in a variant, the insulator border 3b can be omitted (plate-through electrode) in which case the electrode tip must be insulated separately.

Fig. 2 is a schematic cross-section of a portion of a piezoceramic actuator according to another embodiment of the invention. Fig. 2 shows a plurality of piezoceramic layers 11 separated by electrodes 13 and 15 embedded in the ceramic. The electrodes are made of a very fine metal wire grid, for instance 5 - 50 µm gauge. The electrodes on fig. 2 are schematized by showing the weft filaments in cross-section and reference numeral 15a designates a warp filament of the electrode. Even numbered electrodes 13 form a group the members of which are connected to a collector electrode 16 and the odd numbered electrodes 15 form another group connected to another collector electrode 17 on the opposite side face of the stack block. It is noted that the position of electrodes 13 and 15 alternate in the stack, i.e. one electrode 13 of a group is followed by an electrode 15 of the other group and so forth.

In this staggered configuration each electrode in a group terminates at a distance 18 from the collector of the other group of electrodes to prevent the collectors to become shorted. This interruption 18 is preferably of a same order of magnitude as the mesh of the wire grid, i.e. the mechanical strength of the ceramic at 18 is the same order of magnitude as that of the ceramic "pillars" between the wires of the mesh. Hence the electrostrictive properties of the stack elements are equilibrated all within the surface of each electrode which strongly enhances the operating life of the actuator. Naturally, as in the previous embodiment, the ceramic border corresponding to 18 can be omitted if desired (eclipsed "plate-through" configuration) in which case the tip of each electrode will have to be insulated separately not to short with the other group's collector nearby.

The metal of the wire mesh can be a refractory metal for instance platinum in case the stack is made by interlaying the wire-mesh electrodes and the piezoceramic layers in green plastic form and thereafter pressing the stack and firing. In case the electrodes are achieved by infiltration, i.e. fugitive electrodes of a consumable material are used, this material is destroyed upon firing, and the resulting voids are thereafter infiltrated with metal; in this case the metal of the electrode can be a low melting metal, e.g. tin, lead or silver and alloys thereof.

Fig. 3 is a schematic view of a portion of another embodiment of actuator according to the invention. Fig. 3 illustrates one piezoceramic layer 22 of a stack and one electrode 23 on top of it. The electrode 23 is made of an array of conductive strips or rods 23a substantially parallel to each other (although this is not critical) and separated from each other by the piezoceramic in which they are embedded. The strips 23a of an electrode are all connected to a collector 26 and terminate on the other side leaving a distance approximately D from the edge nearby. This distance D is preferably of the same order as the distance d between the strips. Hence the mechanical properties of the portions of ceramic around the conductive elements of the electrode may be equilibrated which strongly prolongs the life of the actuator in operation. However, if one prefers to indivudually insulate the tip of each electrode, for instance with a set-in fillet of glass or other high temperature material, the electrodes need no longer be in staggered configuration, but can be of the "plate-through" type. Naturally, the orientation of the conductive strips of this embodiment can be any relative to the electrode itself, for instance the strips can also be at right angle to the position shown in fig. 3.

The present invention also deals with the method for obtaining the present actuator structures. As acknowledged above, two main routes can be followed. In a first route, the electrode material directly provides the electrode metal upon firing, so it can either be the metal itself or a precursor. The metal itself must resist high temperature oxidation, hence it must be refractory like platinum or other precious metals.

In a second route, the method involves making fugitive electrodes, i.e. layers containing a heat decomposable material which, upon firing, will leave voids which can thereafter be filled with metal. Embodiments of fig. 2 and 3 are particularly adapted to this technique in which for instance polymer filaments are involved (monofilament fabric in the case of fig. 2 and array of filaments in the case of fig. 3). It should be noted that in the discussion which follows, each element of the original stack (leaf) can be considered an element of one or of a plurality of actuators, i.e. in this latter case the stacked block is ultimately divided (at the green or sintered stage) by cutting the block transversally to its layers into actuator blocks whose cross-sectional area is a fraction of that of the original block.

For instance, for bringing about the embodiment of fig. 2 whereby an electrode interruption 18 is contemplated, pieces of nylon or polyester monofilament fabric can be embedded between layers of piezoceramic. This can be performed very simply as follows : a layer of piezoceramic paste is deposited on a tape by the tape-casting technique and thereafter, before drying, a nylon fabric strip slightly narrower than the tape and impregnated with the ceramic slurry is applied thereto as a coating in correct registration to leave a thin uncoated bare track on the tape side. The assembly is laminated (for instance between rolls) and dried to plastic consistency. Then the ceramic with nylon fabric embedded therein is cut into leaves of proper size for stacking (a fraction of cm to several cm) and the leaves are piled together in alternate fashion, i.e. orienting the bare side of the even numbered leaves opposite the corresponding side of the odd numbered leaves. Then the stack is pressed to ensure full homogeneity and integrity of the ceramic from top to bottom and then it is fired and sintered in air under usual conditions. During this treatment, the nylon mesh is carbonized and burned leaving corresponding voids in the ceramic. These voids are thereafter infiltrated with molten metal (or a metal derivative in liquid form which thereafter decomposes to the metal) by usual means conventional in the field of ceramic capacitors (see for instance GB-A-2,103,422; US-A-3,679,950). Finally the electrode collector material is applied on the sides of the stack, for instance in the form of an electrically conductive paint or ink, e.g. a silver based ink (see the foregoing references). The aforementioned method can evidently be used also for the embodiment of fig. 3, the nylon strip used in the tape casting step being replaced by a ribbon of comparable width made of substantially parallel filaments of fugitive substance. Naturally, if it is preferred to make "plate-through" electrodes the width of the tape and the nylon strip will be alike.

Regarding the problem of individually insulating the tip of electrodes in the construction of actuators with electrodes of the "plate-through type, it should be recognised that the manufacturing techniques typically used in this invention may strongly simplify the problems of accurately placing, on the actuator sides, the additional insulative strip to cover the bare end of those electrodes to be insulated.

This is particularly so when each leaf of the original stack corresponds to an element of a plurality of final actuator blocks, i.e. when at a later stage the original compacted block is divided longitudinally (transversally to the surface of the elementary layers) into narrower blocks, each of these narrower blocks eventually becoming an actuator after completion.

In an embodiment intended to simplify the application of terminal insulative strips to "plate-through" electrodes, each tape-cast elementary leaf in the dry plastic state is provided by silk-screening with an array of parallel fugitive stripes. The distance between the stripes corresponds to the side of the cross-sectional area of the final actuator blocks after cutting. This is shown in fig. 4 and 5.

Fig 4 shows schematically from above two successive elements or layers A and B to be stacked with other similar layers in actuator manufacture. Fig. 5 shows in cross-section (line VI-VI of fig. 4) a portion of the actual stack achieved by piling successive pairs of layers A and B. Elements A and B are squares of piezoceramic in the plastic state obtained by tape-casting as described previously and cut to size for stacking. After being stacked with their kins into a stack which is thereafter pressed to a block as described, the block is cut vertically along the dotted lines to provide individual blocks of actuator format.

A fugitive pattern of silk-screened parallel stripes 51 is provided on sheet A and a pattern of stripes 52 is provided on sheet B. The stripes can be about 10-150 µm wide and a few µm or a few tens of µm high, i.e. about the height of the electrode structure 54 between the stripes. The electrode structure here can be any of that previously discussed in this application and need not be specified further in this particular manufacturing phase.

It can be seen from fig. 4 that the positions of the stripes 51 and 52 are offset relative to the dotted cutting lines, i.e. stripes 51 are to the left of the lines and stripes 52 and to the right. Hence after burning the fugitive paint and cutting the block to actual actuators as shown schematically in Fig. 6, the departed stripes will leave side grooves 55 in staggered configuration on opposite sides of the potential actuator. In the drawing, reference numeral 56 designates the piezoceramic. The depth of the grooves is considerably exaggerated in the drawing for illustration convenience. The actual depth is only a few µm or a few tens of µm, i.e. a value corresponding to the width of original stripes 51 and 52.

During actuator termination, the grooves are filled with insulator, for instance a high temperature resin like a polyimide resin; alternatively the insulator can be mineral. The advantage of this manufacturing embodiment over the prior art which insulates "plate-through" electrodes by means of glass strips applied over the electrode edges on the side faces of the activator block relates to positioning accuracy and efficiency. It is obviously much more difficult to position insulator fillets on a flat surface without guiding marks than simply filling depressed areas in this surface. Moreover, after insulation, the block side surface is flat (while it is corrugated in the prior art) which facilitates final application of collector electrodes.

The following Examples illustrate the invention in detail:

### Example 1

The following blend was prepared and milled for 24 hrs with a load of zirconia balls:

| | |
|---|---|
| Piezoelectric powder PZT 8, Vernitron Ltd. | 100 g |
| Binder (polyvinylbutyral) | 14 g |
| Plasticizer (polyethylene glycol) | 5 g |
| Plasticizer (dioctylphthalate) | 3 g |
| Organic defloculant agent (triethyl phosphate) | 1 g |
| Solvent (1:1 mixture of trichloroethylene and ethanol) | 75 g |

After removing the milling balls, the thick slurry was cast into a 400 µm thick layer (doctor's blade) on a 30 mm wide MYLAR tape (Du Pont). The casting was dried in air and, when flexible, was removed from the supporting tape. The plastic casting was cut into 30 x 30 mm squares on which a pattern was silk-screened using a carbon-based paint (type 1116-S from Electro-Science Laboratories Inc). The pattern was that of a 150 mesh screen, i.e. having cross-lines 150 µm wide (and 20 µm high) separated by 150 µm.

The prints were dried and the squares were stacked (60 units) in a mould. Pressure was applied (20 MPa, 80°C) to form a monolithic block. In this operation, the plastic ceramic flows into the pattern meshes and integrally binds together the piezoceramic layers, i.e. embeds the screen patterns in the body thereof.

Then the monolithic stack was placed in a pyrolysis oven and slowly heated to 800°C (5°C/hr). After cooling, it was placed in a sintering oven also containing a supply (pressed disks) of a mixture of lead and zirconium oxides and sintered for 2 hrs at 1300°C. At this temperature, the pellets of lead and zirconium oxide evaporate partially and the vapors compensate for possible losses of the piezoceramic during sintering.

After pyrolysis and sintering the stacked block of monolithic piezoceramics comprises a succession of layers of the original printed screen in the form of a pattern of empty channels.

The sintered block was thereafter placed in an enclosure above a pot of molten alloy at 850°C. The alloy was of Ag 68.4% - Cu 26.6% - Pd 5%. The block was first placed under vacuum (40 mbar) to remove the residual atmosphere in the inner channels, then it was slowly immersed in the molten alloy and an inert gas pressure of 15 MPa was established for about 15-30 min whereby the molten metal was forced within the pores in the block. The metal was allowed to solidify under pressure after which the block was withdrawn from the enclosure.

The block was thereafter sawed vertically into several actuator blocks of 5 x 5 mm cross-sectional area.

On both sides of the actuators were applied by the silk-screen method a plurality of parallel insulator glass-paste fillets covering the edges of the embedded metal filled electrode layers. On one side of the block the fillets covered in alternation the end of the even numbered electrodes and on the other side the fillets covered in alternation the tip of the odd-numbered electrodes. The actuators were thereafter baked for an hour at 700° to effect welding of the protective fillets. Then both sides of the actuator with the fillets were coated with a layer of a silver based paint to constitute two collector electrodes, one collector for connecting with the odd-numbered electrodes and another collector for the even-numbered electrodes. Then the actuator was completed by soldering electric terminals to the collectors and finally sealed in a resin. After usual polarization for conditioning, the actuator was subjected to tests which demonstrated superior performances and service life.

### Example 2

In this Example, there were used a casting tape similar to that used in Example 1 and a nylon monofilament fabric strip of same width. The nylon fabric was a 82 µm mesh gauge woven with 30 µm thick monofilaments. The strip and the tape were applied in registration against each other and a layer of the same slurry of piezoelectric PZT ceramic was cast over the strip supported by the tape.

After drying, the flexible composite casting (130 µm thick) containing the nylon fabric embedded in the lower part thereof was removed and cut into square leaves 30 mm aside.

The squares (60 units) were piled up in a mould and the resulting stack was pressed as described in the previous Example to assure full cohesion of the layers together by forming ceramic "bridges" through the nylon fabric meshes.

Then the stack was fired and sintered as described in Example 1, whereby the fugitive nylon filaments volatilized leaving in the block a succession of inlaid layers of criss-crossing empty channels in the form of the original fabric pattern.

The monolithic block was thereafter infiltrated with a molten lead-silver (90/5) alloy at 310°C using the same technique disclosed in Example 1 and finally cut into actuator stacks of 5 mm side cross-sectional area. Each actuator was then constituted by a stack of 60 parallel metal electrodes embedded in the piezoceramic. Of these 60 electrodes, the even-numbered ones were to be connected to a first collector on a first side of the actuator and the odd-numbered electrodes had to be connected to a second current collector placed on the opposite side of the block. Hence the edge of the odd-numbered electrodes on the first collector's side had to be insulated individually not to become in contact with said first collector upon application of said first collector on the first side of the block. This insulation was provided by applying, by the silk-screen technique on the first side of the block, parallel resin strips or fillets which cover the tip edge of the odd-numbered electrodes where level with the first side of the block. The same operation was carried out on the opposite side for the edges of the even-numbered electrodes. The resin used was a polyimide resin (EPO-TEX 600, of Epoxy Technology Inc.) Polymerization was effected by heating for 1 hour at 150°C then for half an hour at 275°C.

Then by usual means known from those skilled in the manufacture of electronic components, the external collector electrodes were formed on both sides of the block including the polymide insulator strips using an electrically conductive curable paint, and terminal lead wires were soldered by means of an electrically conductive glue. Then the actuator was sealed into protective resin and conditioned by polarization. This embodiment also behaved very satisfactorily under testing.

It should be noted that according to a variant of this example, one can also use for instance a 10 mm wide tape in conjunction with a 9 mm wide nylon strip centered on the tape, i.e. leaving on both sides a 0.5 mm uncovered margin. After casting and removing from the tape, the flexible structure can be slit axially and the obtained segments cut by a multiple of the length of an actuator side, say, into 30 mm lengths. These portions can be stacked in alternate fashion, i.e. each time reversing the position of the margin of the new segment relatively to that of the previous one. Then the assembly can be compacted, burned, sintered, infiltrated with molten metal and finally cut into actuator blocks in which each electrode terminates about 0,5 mm from the opposite side of the actuator. Hence each electrode of a group is insulated from the collector of the other group of electrodes during actuator compaction and the application of individual insulator fillets to the electrode end are no longer necessary. Finally the actuator is completed by depositing the layers of conductive paint which contitute the terminal electrodes on the collector sides.

## Claims

1. A method for manufacturing a multilayer piezoceramic actuator stack comprising the steps of :
a) forming leaves of piezoceramic (11,22,56) in the plastic state by tape casting:
b) forming electrode layers (3,13,23) of a material being either in fugitive or final permanent form to be interposed between the piezoceramic leaves (1,2,11,22), each of said electrode layers being patterned so as to provide an array of local interruptions or discontinuities therethrough being filled with piezoceramic material;
c) piling over each other a plurality of leaves (11,22,56) and electrode layers (3,13,23) in alternating succession such that alternate electrode layers leave insulating margins at opposite side faces in the final actuator structure comprising thus even- and odd-numbered electrode members ;
d) pressing the stacked eaves (11,22,56) into a compact block to effect integral binding of the layers within the stack, whereby forcing the plastic ceramic to fill the local interruptions or discontinuities in the electrode layers (3,13,23);
e) firing to sinter the block and, when the electrode pattern is fugitive, volatilizing the fugitive electrode material thus providing voids in the ceramic in the form of the electrode pattern;
f) when voids are present, filling the voids by infiltration with metal in order to achieve the final electrodes in the desired pattern:
g) connecting the even-numbered electrodes (13) to a common collector electrode (16) and the odd-numbered electrodes (15) to another common collector electrode (17), the collector electrodes being applied over opposite sides of the stack block;
in said method, steps (a) and (b) are effected by casting a layer of piezoceramic (11,22,56) on a tape supporting a ceramic impregnated ribbon of wire or filament fabric (13,15), at least one edge of tape and ribbon being made flush with each other, laminating together said ribbon and said tape cast ceramic layer, drying the laminate and cutting it into leaves.

2. The method of claim 1, in which said fabric (13,15) is a metallic wire mesh, whereby the electrode material is permanent.

3. The method of claim 1, in which said fabric (13,15) is of organic polymer monofilaments, whereby said polymer is volatilized during firing leaving an empty pattern to be thereafter filled with metal by infiltration.

4. The method of claim 1 in which after steps (d) or (e) the compacted block is cut vertically, transversally to the stacked layers (56), to provide a plurality of actuator shaped blocks of cross-sectional area narrower than that of the original stack, each of said narrower blocks being therafter terminated into actuator proper according to the remaining manufacturing steps (f) and (g).

5. The method of claim 4, in which the direction of cutting of the stacked block corresponds to two sets of parallel lines (VI,VII) which intersect at right angle, the cross-sectional area of the narrower blocks of actuator format being square or rectangular.

6. The method of claim 5, in which, step (b), includes applying stripes of fugitive material on each piezoceramic leaf (56) along the lines of one of said set of lines, the cutting of the compacted block and the burning of said fugitive material eventually resulting in the formation of grooves (51,52) in staggered configuration on opposite sides of the narrower actuator formatted blocks, these grooves being thereafter filled with insulator material to effect individual insulation at the tip edge of each corresponding electrode layer of the actuator.

## Patentansprüche

1. Verfahren zur Herstellung einer piezokeramischen Vielschichtstapel-Antriebsvorrichtung mit den Schritten,
a) piezokeramische Folien (11, 22, 56) durch Bandguss im plastischen Zustand zu formen;
b) aus einer flüchtigen oder einer endgültigen, dauerhaften Form eines Materials Elektrodenschichten (3, 13, 23) auszubilden, die zwischen die piezokeramischen Folien (1, 2, 11, 22) eingefügt werden, wobei jede der benannten Elektrodenschichten so gestaltet ist, dass sie von einer Reihe von lokalen Unterbrechungen oder Diskontinuitäten durchzogen ist, die mit piezokeramischem Material gefüllt werden;
c) eine Mehrzahl von Folien (11, 22, 56) und Elektrodenschichten (3, 13, 23) abwechselnd so übereinanderzustapeln, dass in der endgültigen Stapelstruktur der Antriebsvorrichtung durch die Elektrodenschichten abwechselnd isolierende Ränder an gegenüberliegenden Seiten belassen werden und der Stapel somit geradzahlige und ungeradzahlige Elektrodenglieder enthält;
d) die gestapelten Folien (11, 22, 56) zu einem dichten Block zu pressen, um eine integrierende Verkittung der Schichten im Stapel zu erzielen, wobei das plastische keramische Material gezwungen wird, die lokalen Unterbrechungen oder Diskontinuitäten in den Elektrodenschichten (3, 13, 23) zu füllen;
e) zu brennen, um den Block zu sintern und, sofern das Elektrodenmuster flüchtig ist, das flüchtige Elektrodenmaterial zu verflüchtigen und dadurch Poren in der Gestalt des Elektrodenmusters in der Keramik zu schaffen;
f) die Poren, sofern vorhanden, durch Einfiltrierung mit Metall zu füllen, um die endgültigen Elektroden im gewünschten Muster zustandezubringen; und
g) die geradzahligen Elektroden (13) mit einer gemeinsamen Sammelelektrode (16) und die ungeradzahligen Elektroden (15) mit einer anderen gemeinsamen Sammelelektrode (17) zu verbinden, wobei die Sammelelektroden auf gegenüberliegenden Seiten des Stapelblocks angebracht werden;
worin Schritte (a) und (b) durch Giessen einer Schicht von piezokeramischem Material (11, 22, 56) auf ein Band ausgeführt werden, das ein mit keramischem Material durchtränktes Band aus Draht- oder Fadengewebe (13, 15) trägt, wobei die beiden Bänder mit zumindest einer Kante bündig gemacht werden; das benannte durchtränkte Band und die benannte, durch Bandguss hergestellte keramische Schicht laminiert werden; und das Laminat getrocknet und in Folien geschnitten wird.

2. Verfahren gemäss Anspruch 1, worin das benannte Gewebe (13, 15) ein Metalldrahtgeflecht ist, in welchem Falle das Elektrodenmaterial dauerhaft ist.

3. Verfahren gemäss Anspruch 1, worin das benannte Gewebe (13, 15) aus organischen Polymer-Einzelfäden besteht, in welchem Falle das benannte Polymer während des Brennens verflüchtigt wird und ein Leermuster hinterlässt, das danach durch Einfiltrierung mit Metall gefüllt wird.

4. Verfahren gemäss Anspruch 1, worin der gepresste Block nach dem Schritt (d) oder (e) quer durch die gestapelten Schichten (56) senkrecht zerschnitten wird, um eine Mehrzahl von Blöcken in der Grösse der Antiebsvorrichtungen zu schaffen, die in ihrem Querschnitt kleiner als der ursprüngliche Stapel sind, wobei jeder der benannten kleineren Blöcke danach entsprechend den übrigen Herstellungsschritten (f) und (g) zu einer eigentlichen Antriebsvorrichtung fertigverarbeitet wird.

5. Verfahren gemäss Anspruch 4, worin die Schnittrichtung des gestapelten Blocks zwei Familien von sich rechtwinklig kreuzenden parallelen Linien (VI, VII) entspricht und der Querschnitt der kleineren Blöcke in der Grösse der Antriebsvorrichtungen quadratisch oder rechteckig ist.

6. Verfahren gemäss Anspruch 5, worin Schritt (b) einschliesst, Streifen eines fliichtigen Materials entlang der Linien einer der benannten Familien von Linien auf jeder piezokeramischen Folie (56) aufzubringen und worin das Zerschneiden des gepressten Blocks und das Brennen des benannten fliichtigen Materials letztlich zur Bildung von Rillen (51, 52) in versetzter Anordnung auf den gegenüberliegenden Seiten der kleineren Blöcke in der Grösse der Antriebsvorrichtungen führt, wobei diese Rillen danach mit isolierendem Material gefüllt werden, um entlang ihrer Kanten jede entsprechende Elektrodenschicht der Antriebsvorrichtung einzeln zu isolieren.

## Revendications

1. Procédé de fabrication d'un empilement actionneur piézocéramique multicouches comprenant les étapes de:
a) former les feuilles de piézocéramique (11,22,56) à l'état plastique par coulage en bande;
b) former des couches d'électrodes (3,13,23) d'un matériau qui est soit sous forme fugitive soit sous forme permanente finale pour être interposées entre les feuilles piézocéramique (1,2,11,22), chacune desdites couches d'électrodes étant modelée de manière à former une rangée d'interruptions ou de discontinuités focales à travers elle, remplies d'un matériau piézocéramique;
c) empiler l'une sur l'autre une pluralité de feuilles (11,22,56) et de couches d'électrodes (3,13,23) en succession alternée telle que les couches d'électrodes laissent des marges isolantes sur les faces latérales opposées dans la structure d'actionneur finale, comprenant ainsi des électrodes paires et impaires;
d) presser les feuilles empilées (11,22,56) en un bloc compact pour produire la liaison totale des couches dans la pile, par laquelle on force la céramique à l'état plastique à remplir les interruptions ou les discontinuités dans les couches d'électrodes (3,13,23);
e) cuire pour fritter le bloc et lorsque l'électrode est sous forme fugitive, volatiliser le matériau de l'électrode fugitive, ménageant ainsi des vides dans la céramique de la forme de l'électrode;
f) lorsque les vides sont présents, remplir les vides par infiltration avec du métal afin d'obtenir les électrodes finales de la forme désirée;
g) connecter les électrodes paires (13) à une électrode collectrice commune (16) et les électrodes impaires (15) à une autre électrode collectrice commune (17), les électrodes collectrices étant appliquées sur des côtes opposés du bloc empilé;
dans ce procédé les étapes (a) et (b) sont effectués par coulage d'une couche de piézocéramique (11,22,56) sur une bande supportant un ruban de fil métallique ou de tissu de filaments imprégné de céramique (13,15), au moins un bord de la bande et du ruban étant à fleur l'un de l'autre, on lamine ensemble ce ruban et ladite couche de céramique coulée en bande, on sèche le stratifié et on le coupe en feuilles.

2. Procédé selon la revendication 1, dans lequel ledit tissu (13,15) est un treillis de fils métalliques, de sorte que le matériau de l'électrode est permanent.

3. Procédé selon la revendication 1, dans lequel ledit tissu (13,15) est en monofilaments de polymère organique, de sorte que ledit polymère est volatilisé durant la cuisson, laissant un espace vide à remplir ensuite de métal par infiltration.

4. Procédé selon la revendication 1, dans lequel après les étapes (d) ou (e) le bloc compacté est coupé verticalement, transversalement aux couches empilées (56), pour former une pluralité de blocs en forme d'actionneurs de superficie en coupe transversale plus étroite que celle de l'empilement initial, chacun desdits blocs plus étroit étant ensuite terminé en actionneurs proprement dit selon les étapes de fabrication restantes (f) et (g).,

5. Procédé selon la revendication 4, dans lequel la direction de coupe du bloc empilé correspond à deux jeux de lignes parallèles (VI, VII) qui se coupent à angle droit, la surface en coupe transversale de blocs plus étroits du format d'actionneur étant carrée ou rectangulaire.

6. Procédé selon la revendication 5, dans lequel l'étape (b) consiste à déposer des bandes de matière fugitive sur chaque feuille piezocéramique (56) le long des lignes de l'un desdits jeux de lignes, la découpe du bloc compacté et le brûlage dudit matériau fugitif aboutissant finalement à la formation de gorges (51, 52) en configuration décalée sur les côtés opposés des blocs d'actionneurs plus étroits mis au format, ces gorges étant ensuite remplies d'un matériau isolant, pour produire l'isolation individuelle au bord d'extrémité de chaque couche d'électrode correspondante de l'actionneur.
